(19) Europäisches Patentamt / European Patent Office / Office européen des brevets

(11) **EP 4 616 496 B1**

(12) **EUROPEAN PATENT SPECIFICATION**

(45) Date of publication and mention
of the grant of the patent:
**06.05.2026   Bulletin 2026/19**

(21) Application number: **23818119.2**

(22) Date of filing: **08.11.2023**

(51) International Patent Classification (IPC):
*H01S 5/00* (2006.01)        *H01S 5/068* (2006.01)
*H01S 5/14* (2006.01)        *G01R 31/26* (2020.01)
*H01S 5/023* (2021.01)        *H01S 5/024* (2006.01)
*H01S 5/06* (2006.01)        *H01S 5/02325* (2021.01)

(52) Cooperative Patent Classification (CPC):
**H01S 5/0014; G01R 31/2635; H01S 5/06812;
H01S 5/141;** H01S 5/02325; H01S 5/02415;
H01S 5/0617

(86) International application number:
**PCT/IT2023/050248**

(87) International publication number:
**WO 2024/100689 (16.05.2024 Gazette 2024/20)**

(54) **METHOD AND SYSTEM FOR CHARACTERISING A BATCH OF GAIN CHIPS**

VERFAHREN UND SYSTEM ZUR CHARAKTERISIERUNG EINER CHARGE VON
VERSTÄRKUNGSCHIPS

PROCÉDÉ ET SYSTÈME DE CARACTÉRISATION D'UN LOT DE PUCES À GAIN

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **10.11.2022   IT 202200023208**

(43) Date of publication of application:
**17.09.2025   Bulletin 2025/38**

(73) Proprietor: **Careglance Srl
20135 Milano (IT)**

(72) Inventors:
• **UBALDI, Maria Chiara
20135 Milano (IT)**
• **VALLONE, Marco Ernesto
20135 Milano (IT)**

(74) Representative: **Tirloni, Bartolomeo et al
BTA Srl
2nd floor
Viale Papa Giovanni XXIII, 106
24121 Bergamo (IT)**

(56) References cited:
**US-A1- 2012 268 743     US-A1- 2022 131 334**

• **VIZBARAS AUGUSTINAS ET AL: "GaSb Swept-
Wavelength Lasers for Biomedical Sensing
Applications", IEEE JOURNAL OF SELECTED
TOPICS IN QUANTUM ELECTRONICS, IEEE,
USA, vol. 25, no. 6, November 2019 (2019-11-01),
pages 1 - 12, XP011734583, ISSN: 1077-260X,
[retrieved on 20190711], DOI: 10.1109/
JSTQE.2019.2915967**
• **WANG TIANFANG ET AL: "High spectral purity
GaSb-based blazed grating external cavity laser
with tunable single-mode operation around
1940nm", UNIVERSITY OF CHINESE ACADEMY
OF SCIENCES, vol. 29, no. 21, 11 October 2021
(2021-10-11), pages 33864, XP093048079, DOI:
10.1364/OE.439255**

**Description**

Technical field of the invention

The present invention relates to a method, and an associated system, for characterizing a batch of gain chips, for example for an external-cavity laser.

Prior art

Typically, a gain chip has an anode and a cathode which can be connected to a power supply source (e.g., two poles of a voltage generator) in order to cause current to flow in the gain chip. This flow of current brings about the generation of a light beam (electromagnetic radiation), which is propagated in a guided manner within the waveguide of the gain chip. Typically, the waveguide of the gain chip extends between two end faces of the gain chip, wherein a first face has a behaviour (at least partially) reflective (e.g., it behaves like a mirror) and a second face has a semi-reflective or anti-reflective behaviour (e.g., thanks to the presence of one or more anti-reflection layers deposited on the second face and/or thanks to the non-orthogonality of the second face relative to the waveguide).

Gain chips can be used as a gain medium, for example in the production of tunable lasers and/or external-cavity lasers which are highly stable.

In the context of the application of a gain chip as a gain medium, it is important to characterize the gain chip, in order to determine the properties of the gain chip and predict its behaviour in the laser. Documents US10732105B1 and US2012268743A1 describe a respective method, and associated system, for characterizing a gain chip.

Document VIZBARAS AUGUSTINAS ET AL: "GaSb Swept-Wavelength Lasers for Biomedical Sensing Applications", IEEE JOURNAL OF SELECTED TOPICS IN QUANTUM ELECTRONICS, IEEE, USA, vol. 25, no. 6, November 2019 (2019-11), pages 1-12, discloses a method for characterizing a gain chip by providing indications of selected microstructural properties of the gain chip.

Summary of the invention

"Gain chip" means a semiconductor (gain) element with an active optical waveguide.

The terms "optical" and "light" refer to electromagnetic radiation that falls within an range extending beyond the visible optical band, and does not necessarily fall strictly within the visible optical band (i.e., approximately 400-700 nm), for example this range extending beyond the visible optical band typically includes near-infrared (for example, wavelength comprised between about 700 nm and about 2 $\mu$m) and/or ultraviolet (for example, wavelength comprised between about 150 nm and about 400 nm).

"Quantum efficiency" (or more properly "external quantum efficiency") means, for example, the number of photons that leave the gain chip for each electron-hole recombination event (further details can be found, for example, in G. P. Agrawal and N.K. Dutta, Semiconductor Lasers, e.g., Eq. (2.6.10)).

"Differential quantum efficiency" (or more properly "differential external quantum efficiency") means, for example, the local value of the quantum efficiency, i.e., the value around a given value of supply current in a regime of linearity of the optical power-power supply current curve.

"Carrier density at transparency" means, for example, the concentration of charge carriers at which the photon emission rate is equal to the photon absorption rate (further details can be found, for example, in G. P. Agrawal and N.K. Dutta, Semiconductor Lasers).

"Modal gain coefficient" ($g_0$) means, for example, a parameter defined by the relation $g_0 = \Gamma g_t$, where $\Gamma$ is a confinement coefficient of the optical mode considered (e.g., the fundamental transverse electric mode TE00), preferably having a value comprised between 0 and 1 (excluding the endpoints), and $g_t$ is the gain coefficient of the material (of which the gain chip is made).

The Applicant has realized that the known methods and systems for characterizing a gain chip have several drawbacks and/or can be improved in some respects.

For example, the Applicant has observed that gain chip manufacturers supply gain chips together with the (nominal) values of several macroscopic parameters of the gain chip, such as, for example, the threshold current of the gain chip, i.e., the current value below which the gain chip (when inserted into the cavity of a laser) generates only amplified spontaneous emission, or ASE (in other words, the current value above which the gain equals the internal losses and the cavity losses, e.g., due to mirrors).

The Applicant believes that the macroscopic parameters of the gain chip may not be sufficient to provide complete indications about the behaviour of the gain chip, especially the long-term behaviour. If the device comprising the gain chip is used in applications in places that are difficult to access (e.g., at the bottom of the sea and/or inside complex operating systems) and/or require a long period of operation, the result may be a use of non-optimal chips, which, in the event of malfunctioning and/or failure, can require a complex and/or costly replacement and/or maintenance.

The Applicant has further observed that the real values of the macroscopic parameters of the gain chips in each production batch may not correspond to the nominal values declared by the manufacturer. For example, in order to reduce costs and/or production times, gain chip manufacturers carry out a sampling inspection, i.e., they conduct experimental tests on a low percentage of the gain chips produced, since such experimental tests can prove burdensome from the viewpoint of the costs and/or times of carrying them out and/or can be destructive of the gain chip tested. The Applicant has therefore addressed the problem of characterizing a batch (e.g., a production and/or sales and/or inventory batch, also a numerically large one) of gain chips in a simple and/or quick and/or reliable and/or economical way, while at the same time determining one or more gain chip parameters which are indicative of the potential real performance of the given gain chip, for example for the purpose of selecting the gain chip that is most suitable for the specific application of interest.

According to the Applicant, the aforesaid problem is solved by a method, and an associated system, for characterizing a batch of gain chips in accordance with the appended claims and/or having one or more of the following features. According to one aspect, the invention relates to a method for characterizing a batch of gain chips according to claim 1.

Exemplarily said gain chip emits from said second face said respective first and/or second light beam.

Exemplarily said respective first first-order diffracted beam enters a waveguide of said gain chip through said second face.

Exemplarily said respective second first-order diffracted beam does not enter the waveguide of the gain chip. According to one aspect, the invention relates to a system for characterizing a batch of gain chips according to claim 7.

The Applicant, without wishing to be limited to any theory, believes that the differential quantum efficiency, the modal gain coefficient and the carrier density at transparency are (microscopic) parameters of the gain chip which provide reliable and/or significant and/or complete indications about the (micro)structural properties of the gain chip, and that they thus allow for reliably predicting the behaviour of the gain chip, in particular the long-term behaviour. In this manner, it is possible, for example, to accurately select the most suitable, or optimal, gain chip for a given application. The Applicant also believes that the method of the present invention is highly reliable and/or simple and/or shows a high consistency of results, since the calculation of the differential quantum efficiency, of the modal gain coefficient and of the carrier density at transparency is made as a function of predetermined mathematical correlations (derived from suitable physical-mathematical models) and as a function of pairs of values of supply current and of optical power which are measurable in an accurate and/or simple and/or rapid manner and/or by exploiting easily available equipment.

The Applicant observes that, with the reflective diffraction grating in the first angular position, the first-order diffracted beam returns towards the gain chip and re-enters the waveguide of the gain chip. Subsequently, the first-order diffracted beam is (at least in part) reflected by the first face of the gain chip and is once again amplified in the waveguide. The Applicant has observed that, in this manner, it is possible to measure the optical power of the first zero-order diffracted beam under a lasing condition. When the reflective diffraction grating is oriented in the second angular position, the first-order diffracted beam does not re-enter the waveguide of the gain chip (in other words, it is lost). In this manner, it is possible to measure the optical power of the first zero-order diffracted beam under a condition of amplified spontaneous emission (ASE). The Applicant has realized that it is advantageous to characterize the gain chip under the two aforesaid different operating conditions (lasing and ASE) and that these different operating conditions are advantageously obtainable in a simple manner using a single test bench. This therefore enables a simplification and/or reduction in the characterization costs and/or times and at the same time a complete and/or comprehensive characterization of the gain chip. In particular, the Applicant has realized that the reflective diffraction grating orientable between two different angular positions allows the current operating condition of the gain chip to be changed in a simple and rapid manner.

The Applicant observes that the characterization method and system according to the present invention are the result of long, extensive analyses and tests, which have led to an accurate and intentional selection, among the countless possible choices, of the instrumental components, test method and detected microscopic parameters that are most suitable for achieving the objective of great structural and/or operational simplicity, rapidity of execution and high repeatability of the results. In this manner it is possible (e.g., for the manufacturer and/or a user of the gain chip) to test up to 100% of a batch of gain chips with industrially acceptable costs and times.

In one or more of the aforesaid aspects, the present invention can have one or more of the following preferred features. Typically, said reflective diffraction grating is of the "blazed grating" type (also known as "echelette grating"), i.e., a diffraction grating comprising a plurality of teeth on a first face of the grating, wherein said plurality of teeth has a constant pitch and, in a cross section (taken along a direction perpendicular to the first face), a step-like pattern with a triangular sawtooth shape.

Typically, said first face of each gain chip is (substantially) entirely reflective and said second face of each gain chip is (substantially) entirely transparent.

In one embodiment, said verifying comprises ordering said gain chips of said batch according to a progressive (e.g., decreasing) order of one or more of said respective differential quantum efficiency, said respective modal gain coefficient and said respective carrier density at transparency. In this manner it is advantageously possible to make a comparison among the gain chips of the batch, by identifying one or more gain chips having given performance features.

Preferably, said respective predetermined selection criterion comprises a respective predetermined threshold value. In this manner it is possible to verify, in a simple manner, which chips have one or more microscopic parameters above a desired value.

Preferably, said verifying comprises:

- as a function of said respective differential quantum efficiency, said respective modal gain coefficient and said respective carrier density at transparency of each gain chip, determining a respective statistical set for each of said differential quantum efficiency, said modal gain coefficient and said carrier density at transparency;
- identifying one (or more) gain chips whose respective differential quantum efficiency, whose respective modal gain coefficient and/or whose respective carrier density at transparency represent an outlier in the respective statistical set (e.g., based on a comparison with the interquartile range).

In this manner the Applicant has realized that it is advantageously possible to identify in a simple and/or rapid manner any gain chips not conforming to given applications because of the expected performance features (e.g., a gain chip, possibly similar to the other gain chips of the batch according to the macroscopic parameters, but having a highly different behaviour from the other gain chips of the batch).

For one or more gain chips of the batch, said operations from b1) to b5) can be carried out before said operations from d1) to d5) (said command-and-control unit being programmed and configured to carry out the operations from f1) to f4) before the operations from g1) to g4)) and, for one or more gain chips of the batch, said operations from d1) to d5) can be carried out before said operations from b1) to b5) (said command-and-control unit being programmed and configured to carry out the operations from g1) to g4) before the operations from f1) to f4)).

For one or more gain chips of the batch, said operation c) or said operation e) can be carried out respectively before said operations from d1) to d5) or said operations from b1) to b5) (said processing unit being programmed and configured to carry out the operations i1) and i2) before the operations from g1) to g4) or the operations m1) and i2) before the operations from f1) to f4)). In other words, the calculation of the microscopic parameters of the gain chips is carried out at the end of the respective acquisition of the measured data, and before starting the subsequent acquisition of the data under another operating condition of the chip.

For one or more gain chips of the batch, said operation c) and said operation e) can both be carried out at the end of all said operations from b1) to b5) and said operations from d1) to d5) (said processing unit being programmed and configured to carry out the operations i1), i2), and m1), m2) at the end of all the operations from f1) to f4) and from g1) to g4)). In other words, the calculation of the microscopic parameters of the gain chip is carried out at the end of both acquisitions under the two operating conditions of the chip.

Preferably, said test bench comprises a collimating lens interposed between said positioning device and said reflective diffraction grating and structured to collimate said first and said second light beam.

Preferably, prior to said operations b3) and d3), it is envisaged to collimate said first and said second light beam. Preferably, said test bench comprises a light beam profiler, more preferably aligned with said positioning device, structured to measure a profile of a light beam (e.g., a cross-section shape of said light beam).

Preferably, said command-and-control unit is operatively connected to said light beam profiler.

Preferably, said test bench comprises a second actuator, preferably multi-axis, e.g., with five axes (e.g., three translational axes and two rotational axes), structured to move said collimating lens in space (along said axes).

Preferably, said command-and-control unit is operatively connected to said second actuator.

Preferably, said test bench comprises a mechanical arm (motorized, e.g., rotating about a rotation axis) structured to move said reflective diffraction grating between an operative position (in which it intercepts said light beams), and a non-operative position, in which said reflective diffraction grating does not intercept said light beams. It is observed that the first and second angular positions are achieved with the reflective diffraction grating in the operative position (in other words, orienting said reflective diffraction grating in said first or second angular position comprises positioning said grating in said operative position).

Preferably, said command-and-control unit is operatively connected to said mechanical arm.

Preferably, preliminarily (e.g., before said operations b1) and d1)), it is envisaged to position said reflective diffraction grating in said non-operative position. Preferably, said command-and-control unit is programmed and configured to, preliminarily (e.g., before said operations f1) and g1)), command said mechanical arm to position said grating in said non-operative position.

Preferably, preliminarily (and after positioning said reflective diffraction grating in said non-operative position), said command-and-control unit is programmed and configured to command said second actuator to position said collimating lens in space.

Preferably, preliminarily (and after said positioning of said collimating lens in space), it is envisaged (said command-and-control unit is programmed and configured to command said supply source) to supply said gain chip with a test value of supply current so that said gain chip emits a test light beam, it is envisaged (e.g. by means of said collimating lens) to collimate said test light beam (to obtain a collimated test light beam), and it is envisaged to measure (said command-and-control unit is programmed and configured to receive from said light beam profiler a measurement of) a profile of said collimated test light beam.

Preferably, it is envisaged (said processing unit is programmed and configured to receive from said command-and-control unit said profile of said collimated test light beam) to verify that said profile satisfies a predetermined profiling criterion.

In this manner it is advantageously possible to transform the light beam emitted by the gain chip, which typically has high divergence, into a light beam with low divergence.

Preferably, said test bench comprises a mirror structured to reflect said respective first (and possibly said second) first-order diffracted beam towards said reflective diffraction grating. Preferably, (at least) during said operations from b1) to b5) and said operations from d1) to d5) (or said operations from f1) to f4) and said operations from g1) to g4)) it is envisaged to maintain said mirror fixed in space.

Preferably, said test bench comprises a third actuator structured to modify a spatial position of said mirror. Preferably, said command-and-control unit is operatively connected to said third actuator.

In this manner, for every gain chip under examination, it is possible to create an external laser cavity by acting on the actuators of the grating and the mirror.

Preferably, said first predetermined mathematical correlation is based on the following first formula:

$$P_{opt} = \eta_d \frac{h v}{q} (I - I_{th}) \qquad (1)$$

where $P_{opt}$ is said optical power, $I$ is said supply current, $I_{th}$ is a threshold current of said gain chip (typically predetermined), $\eta_d$ is said differential quantum efficiency, $h$ is the Planck constant, $v$ is a photon frequency (typically predetermined, e.g. corresponding to a wavelength at which a gain peak of said gain chip occurs, this wavelength being, for example, a central wavelength in a tuning range of the gain chip), and q is the electron charge.

The Applicant, without wishing to be limited to any theory, has observed that the use of the aforesaid formula, which correlates the optical power and the supply current with the reflective diffraction grating in the first angular position (i.e., with the gain chip that creates a mirror of the external laser cavity), provides reliable and repeatable results on the detected values of differential quantum efficiency, in a simple and rapid manner. Therefore, the Applicant believes to have made a selection, among the various available physical-mathematical models, of a model that is particularly advantageous for the pre-established purpose.

Preferably, said operation c) (or said operation i2)) comprises determining a first function, preferably linear, that interpolates said (first) plurality of pairs of first values of supply current and of optical power.

Preferably, said first linear function is determined by linear regression of said plurality of pairs of first values of supply current and of optical power. In this manner the line that interpolates the pairs of values of supply current and of optical power is obtained in a way that is computationally simple and/or highly accurate.

Preferably, said first linear function is determined at said first values of supply current which are greater than said threshold current of said gain chip. In this manner the linear regression is conducted in the regime of lasing currents (for values of supply current below the threshold current, the optical power is the ASE power, which is substantially negligible). Preferably, said first linear function is determined at said first values of supply current below an upper reference value (e.g., above which the linear correlation between the optical power and the supply current might no longer be true).

Preferably, said first predetermined mathematical correlation is obtained by deriving said first formula as a function of said supply current.

Preferably, said first predetermined mathematical correlation is:

$$\eta_d = \frac{q}{h v} m \qquad (2)$$

where m is an angular coefficient of said first linear function.

Preferably, said second predetermined mathematical correlation is:

$$P_{opt} = \frac{n_{sp} h \nu\, v_g}{L} \frac{g_0 \ln\left(\frac{(\eta I)^{\frac{1}{3}}}{(qVC)^{\frac{1}{3}} N_o}\right)}{g_0 \ln\left(\frac{(\eta I)^{\frac{1}{3}}}{(qVC)^{\frac{1}{3}} N_o}\right) - \alpha_i} \left(e^{\left[L\left(g_0 \ln\left(\frac{(\eta I)^{\frac{1}{3}}}{(qVC)^{\frac{1}{3}} N_o}\right) - \alpha_i\right)\right]} - 1\right) \qquad (3)$$

where $P_{opt}$ is said optical power, $I$ is said supply current, $g_0$ is said modal gain coefficient, $N_o$ is said carrier density at transparency, $n_{sp}$ is a population inversion factor (typically predetermined), $h$ is the Planck constant, $\nu$ is the photon frequency, $v_g$ is a group velocity (in the medium), $L$ is a length of said gain chip (taken along a prevalent direction of extension of the gain chip which goes from said first to said second face), $\alpha_i$ represents internal losses of said gain chip, $\eta$ is an injection efficiency (preferably measurable by means of appropriate experimental tests or, alternatively, predeterminable), C is the Auger recombination coefficient (expressed in $cm^6 s^{-1}$, and preferably measurable by means of appropriate experimental tests or, alternatively, predeterminable), $V$ is a volume of said gain chip, and $q$ is the electron charge.

The Applicant, without wishing to be limited to any theory, has made the following observations. First, the Applicant believes that when the gain chip is supplied with a supply current, the electrons and the holes recombine radiatively. The optical power generated becomes a guided mode and the photon density distribution ($\Phi$) along the direction z (i.e., the direction of the length L of the gain chip) can be expressed by the following formula (4):

$$\frac{d\Phi(I, z)}{dz} = \Phi(I, z)(\Gamma g(I) - \alpha_i) + \frac{n_{sp} \Gamma g(I)}{V} \qquad (4)$$

where $\Gamma$ is the confinement coefficient of the optical mode (e.g., measurable by means of appropriate experimental tests or, alternatively, predeterminable), and $g(I)$ is a gain of the material (of which the gain chip is made). The Applicant also believes that any retro-reflection effects at the first and/or second face of the gain chip may be disregarded. By integrating the formula (4) and assuming the boundary condition $\Phi(I, 0) = 0$, it is possible to obtain the photon density $\Phi(I)$.

The optical power can be expressed by means of the relation $P_{opt} = Sh\nu\, v_g \Phi(I)$, where S is a surface area of the first and/or second face of the gain chip.

Therefore, the optical power at the second face (i.e., output from the gain chip, i.e., with z=L) is given by the relation:

$$P_{opt} = \frac{n_{sp} h \nu\, v_g}{L} \frac{\Gamma g(I)}{\Gamma g(I) - \alpha_i} \left(e^{[L(\Gamma g(I) - \alpha_i)]} - 1\right) \qquad (5)$$

The gain of the material $g(I)$ can be expressed as a function of a carrier density (N) in the active layer of the gain chip (i.e., the region of the gain chip comprising quantum wells), with that gain of the material which can be expressed by the relation:

$$g(N) = g_t \ln\left(\frac{N}{N_o}\right) \qquad (6)$$

where $g_t$ is the gain coefficient of the material (depending on the characteristics of the active layer of the gain chip, such as, for example, the number and thickness of the quantum wells). The Applicant has observed that for low values of supply current (e.g., less than 20 mA), the carrier density (N) is low ($N < N_0$) and the stimulated emission can be disregarded. In fact, under that condition the gain chip absorbs more photons than it emits, i.e., g(N) < 0. As the value of supply current increases, there is a progressive increase in the charge carrier density until arriving at a value of that charge carrier density (i.e., the carrier density at transparency) at which an inversion in the behaviour of the gain chip occurs, that is, the photon absorption rate equals the photon emission rate (i.e., g(N) = 0).

The Applicant has also observed that it is possible to define the modal gain, i.e., an effective gain that a determined optical mode undergoes (e.g., the fundamental electric transverse mode), as the product between the confinement coefficient ($\Gamma$) and the gain of the material (g(N)). The Applicant has identified that at transparency (i.e., for $N=N_0$), the modal gain is defined by the coefficient (defined as modal gain coefficient $g_0$) expressed by the relation $g_0 = \Gamma g_t$. Moreover, in order to express the carrier density (N) as a function of the supply current (I), the Applicant has observed that it is possible to use a transport model (e.g., the model known as "ABC"), which, in the high-density approximation (specific case of local density approximation, or LDA) can be substantially expressed by the formula:

$$I \approx \frac{qV}{\eta} CN^3$$

Therefore, the carrier density N can be substantially expressed according to the relation:

$$N \approx (\frac{\eta I}{qVC})^{1/3}$$

Based on such observations, the Applicant has arrived at the formulation of the aforesaid second predetermined mathematical correlation according to the formula (3). The Applicant has verified that the use of the aforesaid formula (3) provides reliable and repeatable results on the detected values of the modal gain coefficient and carrier density at transparency, in a simple and rapid manner. Therefore, the Applicant believes to have made a selection, among the various available physical-mathematical models, of a model that is particularly advantageous for the pre-established purpose.

Preferably, said calculating of said respective modal gain coefficient and said respective carrier density at transparency comprises calculating a function for the minimization of a residual sum of squares, said minimization function being a function of said second values of optical power and of a plurality of theoretical values of optical power calculated as a function of said second predetermined mathematical correlation. The Applicant has realized that in this manner it is possible to favour a reliable calculation of the modal gain coefficient and of the carrier density at transparency. In other words, said values of modal gain and carrier density at transparency are the values that make said residual sum of squares minimum.

Preferably, said test bench comprises a thermostat structured to maintain said gain chip, positioned in said positioning device, stable in temperature.

Preferably, said command-and-control unit is operatively connected to said thermostat. Preferably, said command-and-control unit is programmed and configured to, during (at least) said operations f2), f3) and g2), g3), command said thermostat to maintain said gain chip at a first temperature.

Preferably, (at least) during said operations from b2) to b4) and said operations from d2) to d4), it is envisaged to maintain said gain chip at a first temperature.

The Applicant has realized that temperature has a large influence on the behaviour of the gain chip and is therefore able to influence (at least in part) the calculation of the microscopic parameters of the gain chip. Consequently, it can be advantageous to carry out the method of the present invention maintaining the temperature of the gain chip constant, at least during the operations of acquiring the optical power (under the two operating conditions), in order to limit the risk that the values calculated for the microscopic parameters might deviate from the real values.

Preferably, said command-and-control unit is programmed and configured to repeat at least said operations from f2) to f4) and said operations from g2) to g4) while maintaining said gain chip at a second temperature, and said processing unit is programmed and configured to repeat said operations i1), i2), m1), m2), and n) (starting from the optical power values measured with the gain chip at the second temperature).

Preferably, it is envisaged to repeat said operations from b2) to b5), and from d2) to d5) while maintaining said gain chip at (at least) a second temperature, and repeating said operations c), e) and n) (starting from the optical power values measured with the gain chip at the second temperature).

The Applicant believes that is advantageous to carry out the acquisitions of the optical power under the two operating conditions (lasing and ASE) with the gain chip at (at least) a second temperature (different from the first temperature), thereby obtaining - the supply current being equal - first and second values of optical power that are different from the ones obtained with the gain chip at the first temperature. Consequently, the value of the microscopic parameters subsequently calculated will also differ, which allows for evaluating the behaviour of the gain chip with variations in temperature. This makes it possible to simulate a condition in which an overheating and/or cooling of the environment surrounding the gain chip occurs, verifying that such temperature variations do not influence (at least not significantly) the behaviour of the gain chip.

Preferably, a difference (in absolute value) between said first and second temperatures is at least equal to 4°C, more preferably at least equal to 8°C. In this manner it is possible to evaluate the behaviour of the gain chip when there are significant temperature variations.

Brief description of the figures

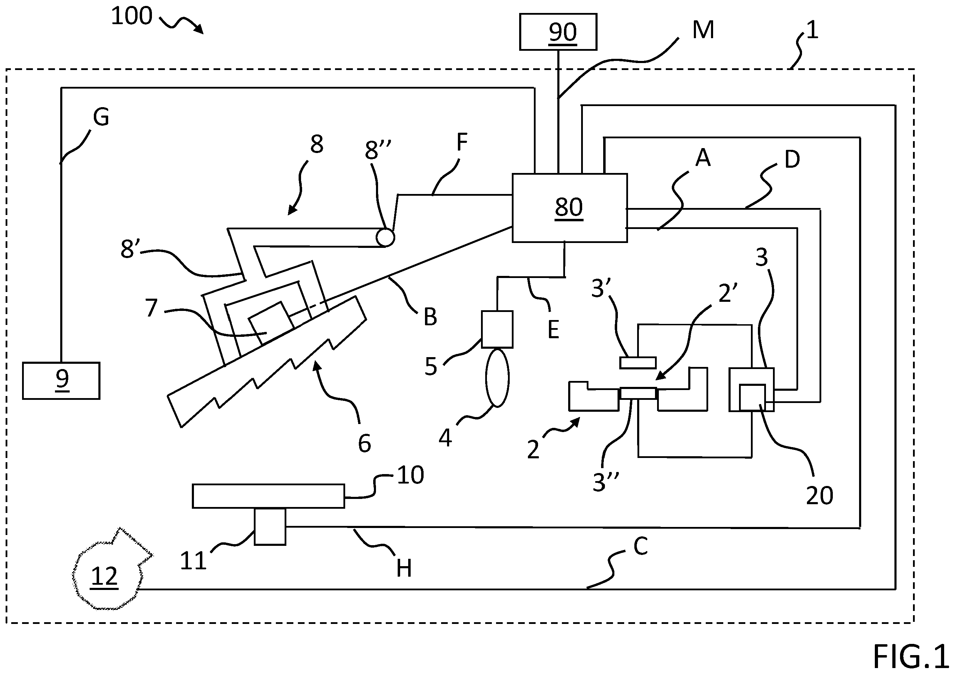

figure 1 schematically shows a system for characterizing a batch of gain chips according to one embodiment of the present invention;

figure 2 schematically shows the characterization system in figure 1 in a preliminary step of an example of the characterization method according to the present invention;

figure 3 schematically shows the characterization system in figure 1 in a first step of an example of the characterization method according to the present invention;

figure 4 schematically shows the characterization system in figure 1 in a second step of an example of the characterization method according to the present invention;

figure 5 shows an example of pairs of values of optical power and supply current obtained in the first step of the method, at two different temperature values of the gain chip;

figure 6 shows an example of pairs of values of optical power and supply current obtained in the second step of the method, at two different temperature values of the gain chip.

Detailed description of some embodiments of the invention

The features and advantages of the present invention will be further clarified by the following detailed description of some embodiments, presented by way of example and not by way of limitation of the present invention, with reference to the appended figures.

In the figures, the reference number 100 denotes in its entirety a system for characterizing a batch of gain chips according to one embodiment of the present invention.

The characterization system 100 comprises a test bench 1 and a processing unit 90.

The test bench 1 comprises a positioning device 2 (shown in a purely schematic manner) which typically comprises a positioning cavity 2' for positioning a gain chip and a plurality of stop elements (not shown) which, when in action, prevent the translation and/or the rotation (about any axis) of the gain chip positioned in the positioning cavity 2'. Although the positioning device 2 is shown in the figures as made up of two distinct bodies, this division has the sole purpose of enabling a clearer representation of the characterization system 100 in its entirety and does not reflect the real structure of the positioning device. By way of example, the positioning device 2 can further comprise, moreover, one or more actuators (not shown) structured to move the stop elements (typically in the range of several micrometres) so that it is possible to reposition the gain chip inserted in the positioning cavity 2'. In this manner, it is possible to simplify the alignment of the components of the characterization system 100.

The test bench 1 comprises a supply source 3 structured to supply a supply current into the gain chip positioned in the positioning device 2. The supply source 3 is for example a voltage generator comprising two electrodes 3' and 3" which are connected at two opposite poles (e.g., anode and cathode) of the gain chip so that the latter is supplied with current. By way of example, the test bench 1 comprises a thermostat 20 (shown only schematically) structured to maintain the gain chip, positioned in the positioning device 2, at a fixed temperature.

For example, the thermostat 20 and the supply source 3 are physically integrated in a single physical device, such as, for example, the LDC-3726 Laser Diode Controller sold by the Newport Corporation.

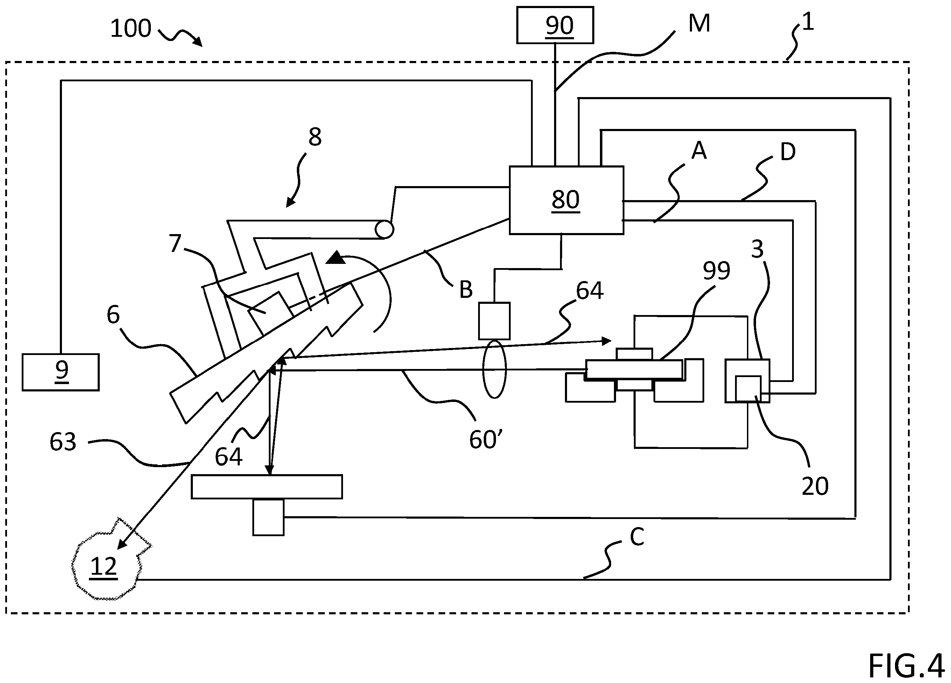

The test bench 1 comprises a reflective diffraction grating 6, typically of the "blazed grating" type (also known as "echelette grating"), and a first actuator 7 structured to orient (with micrometric precision) the reflective diffraction grating 6, e.g., alternatively between a first angular position and a second angular position. By way of example, the diffraction grating 6 is rotatable about an axis perpendicular to the plane of the sheet (as shown by the respective rotation arrow in figure 4).

By way of example, the test bench 1 comprises one (or more) collimating lenses 4, typically aligned with the positioning device 2 (in particular with the positioning cavity) and interposed between the positioning device 2 and the reflective diffraction grating 6.

By way of example, the test bench 1 also comprises a second actuator 5 structured to move the collimating lens 4 in space. For example, the second actuator 5 is capable of adjusting the position of the collimating lens 4 in space along the three translational axes and is capable of rotating the collimating lens 4 about two rotation axes (typically, the collimating lens 4 does not rotate about the rotation axis substantially perpendicular to the main faces of the collimating lens itself).

By way of example, the test bench 1 comprises a motorized mechanical arm 8 comprising a member 8' connected, at a first end, directly to the reflective diffraction grating 6 and, at a second end, to a respective actuator 8" which enables a rotation of the member 8' (for example about a rotation axis perpendicular to the plane of the sheet).

By way of example, the test bench 1 comprises a light beam profiler 9, for example aligned with the positioning device 2 and positioned distally from the positioning device 2 relative to the reflective diffraction grating 6. The profiler 9 is structured to measure a profile of a light beam, for example a cross-section shape of the light beam (i.e., the shape of the light beam on the plane transverse to the direction of propagation of the light beam).

By way of example, the test bench 1 comprises a mirror 10, for example a flat mirror, and, for example, a third actuator 11 structured to orient the mirror 10 in space (e.g., by rotating it about a respective rotation axis, for example perpendicular to the plane of the figures).

The test bench 1 comprises an optical power measuring device 12.

The test bench 1 comprises a command-and-control unit 80 operatively connected (for example by means of a respective wired or wireless communication line) to: - the supply source 3 (via the communication line A);

- the first actuator 7 (via the communication line B); and
- the measuring device 12 (via the communication line C).

By way of example, the command-and-control unit 80 is also operatively connected (e.g., by means of a respective wired or wireless communication line) to:

- the thermostat 20 (via the communication line D);
- the second actuator 5 (via the communication line E);
- the further actuator 8" (via the communication line F);
- the light beam profiler 9 (via the communication line G); e
- the third actuator 11 (via the communication line H).

The characterization system 100 also comprises a processing unit 90 connected to the command-and-control unit 80 (via a respective wired or wireless communication line, indicated by the letter M).

The present invention envisages any arrangement and logical and/or physical distribution both of the processing unit and of the command-and-control unit. Each of such units can for example consist of a respective single physical and/or logical unit or be made up of a respective plurality of physical and/or logical units distinct from and cooperating with each other. Moreover, for the purposes of the present invention, the division between the processing unit and command-and-control unit (as shown in the figures) is purely for illustrative purposes, as such units can be integrated into a single physical and/or logical unit.

Described below is an example of the method for characterizing a batch of gain chips, implementable through the characterization system 100 described above. For example, each gain chip comprises a first entirely reflective face and a second face that is entirely transparent (e.g., thanks to the depositing of anti-reflection layers).

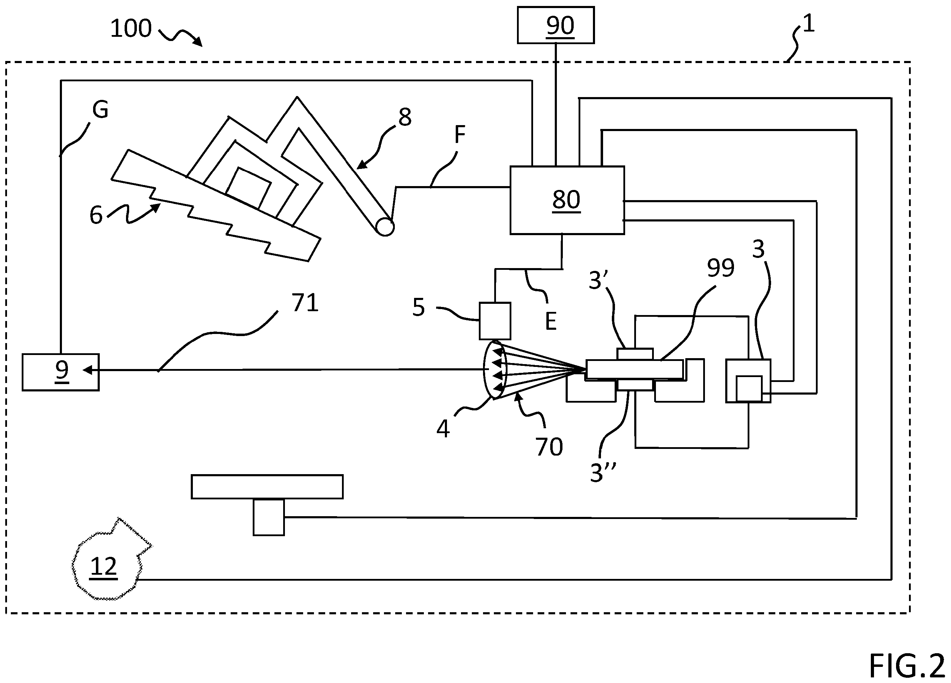

First, the method envisages positioning a first gain chip 99 in the positioning cavity 2' of the positioning device 2 with the second face facing towards the light beam profiler 9, and securing it in the cavity 2' by means of the stop elements. At this point, the method envisages, by way of example, preliminarily carrying out a profiling test (schematically shown in figure 2). The profiling test envisages first activating the mechanical arm 8 (via a command of the command-and-control unit 80) to move the reflective diffraction grating 6 into a non-operative position in which the grating 6 is located outside a line joining the positioning device 2 and the profiler 9. In this manner, only the collimating lens 4 is interposed between the positioning device 2 and the light beam profiler 9. Subsequently, the second actuator 5 is activated in order to position the collimating lens 4 in a first spatial position.

Subsequently, the profiling test envisages supplying the gain chip 99 (by applying a potential difference between the two electrodes 3' and 3", controlled by the command-and-control unit 80) with a test value of the supply current (e.g., 150 mA) so that the gain chip 99 emits a test light beam 70. This light beam is collimated by the collimating lens 4 into a collimated test light beam 71 which is captured by the profiler 9 (without impinging on the reflective diffraction grating 6, which is in the non-operative position).

The light beam profiler 9 measures the profile of the collimated test light beam 71 and sends the result of the measurement to the command-and-control unit 80, which in turn sends this result to the processing unit 90. The processing unit 90 verifies that the profile of the collimated test light beam 71 satisfies a predetermined profiling criterion, for example that the profile of the collimated test light beam 71 is the desired one (e.g., substantially circular). If this profiling criterion is not satisfied, the profiling test envisages repositioning the collimating lens 4 in space, in a second spatial position (e.g., by translating and/or rotating it) and repeating the previous operations.

If, by contrast, the profiling criterion is satisfied, the profiling test is considered concluded.

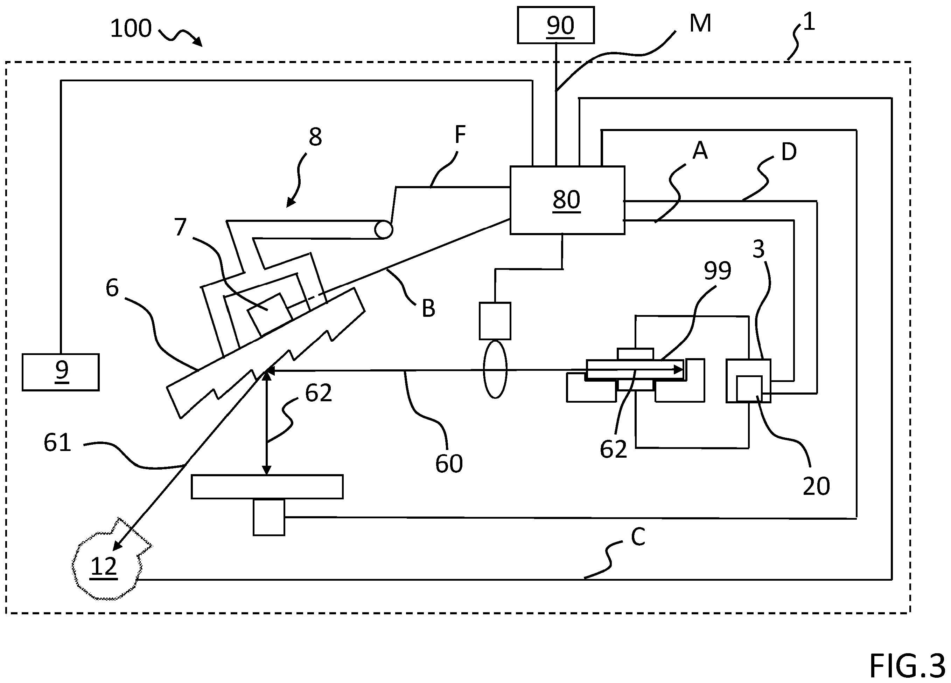

After that, the characterization method envisages activating the mechanical arm 8 (via a command of the command-and-control unit 80) to move the reflective diffraction grating 6 into an operative position in which the grating 6 intersects the line joining the positioning device 2 and the profiler 9 (see figures 3 and 4).

At this point (with reference to figure 3), the characterization method envisages, by way of example, a first step in which the following operations are carried out.

The reflective diffraction grating 6 is oriented in a first angular position (by means of a command signal sent by the command-and-control unit 80 to the first actuator 7).

The gain chip 99 is supplied (e.g., through the application of an appropriate voltage at the electrodes 3' and 3") with a plurality of first values of supply current, for example comprised between 0.05 mA and 310 mA, endpoints included, with increments of 10 mA or 20 mA.

In this manner, the gain chip 99 emits a respective first light beam 60 for each first value of supply current.

Subsequently, each first light beam 60, coming out of the second face of the gain chip 99 with high divergence, is collimated by the collimating lens 4 (positioned in the spatial position determined with the profiling test) and, subsequently, impinges on the reflective diffraction grating 6 in the first angular position (and in the operating condition). This brings about, for each first light beam 60, the generation of a first zero-order diffracted beam 61 and a first first-order diffracted beam 62.

Each first first-order diffracted beam 62 is thus directed towards the mirror 10, is reflected back by the latter towards the reflective diffraction grating 6 along the same direction (as represented by the double arrow that goes from the grating 6 to the mirror 10), and then re-enters the gain chip through the second face (as represented by the arrow inside the gain chip 99).

This operating condition, defined as the lasing condition (i.e. where the gain chip behaves like a laser diode), is possible thanks to the specific angular position of the reflective diffraction grating 6 and the spatial position of the mirror 10, which are such that the grating 6, the mirror 10, and the first reflective face of the gain chip 99 create an external laser cavity. In an example operating embodiment, the actuators 7 and/or 11 are commanded to rotate the grating 6 and/or mirror 10, while simultaneously monitoring the optical power detected by the device 12 on the first zero-order diffracted beam for a given supply current, for example 150 mA. The desired angular position of the grating 6 and of the mirror 10 is the one in which the detected power is maximum (under that condition, the maximum coupling of the first-order diffracted beam with the gain chip is achieved).

It is also possible to create the external laser cavity using alternative configurations of a known type, such as, for example, the Littrow or the Littman-Metcalf configuration.

Each first zero-order diffracted beam 61 is reflected towards the optical power measuring device 12 in order to measure a respective first value of optical power thereof. The first values of optical power are subsequently acquired by the command-and-control unit 80 (via the communication line C), which associates them with the respective first value of supply current, resulting in a first plurality of pairs of first values of supply current and of optical power.

The first plurality of pairs of first values of supply current and of optical power is subsequently transmitted by the command-and-control unit 80 to the processing unit 90 (via the communication line M). The first step of the method concludes with this action.

A second step of the characterization method which, by way of example, is carried out at the end of the aforesaid first step, will now be described with reference to figure 4. Alternatively, the second step can be carried out before the first step.

By way of example, in the second step the following operations are carried out.

The reflective diffraction grating 6 is maintained in the operative position and is oriented in a second angular position (by means of a command signal sent by the command-and-control unit 80 to the first actuator 7). In the passage from the first to the second angular position, the grating 6 undergoes an anticlockwise rotation (represented by the respective arrow in figure 4), preferably of an extent greater than or equal to 1° and/or less than or equal to 10°, more preferably less than or equal to 5°, for example equal to about 3°.

Subsequently, the gain chip 99 is supplied (e.g., through the application of an appropriate voltage at the electrodes 3' and 3") with a plurality of second values of supply current, for example the same values of supply current as used in the first step (i.e., the aforesaid first values of supply current).

In one embodiment, the second values of supply current can be different from the first values of supply current. For example, each second value of supply current can be contained within a respective range of values centred on the respective first value of supply current and having a width, for example, of 5mA.

As mentioned above, the gain chip 99 emits a respective second light beam 60' for each second value of supply current. Each second light beam 60', coming out of the second face of the gain chip 99 with high divergence, is collimated by the collimating lens 4 (maintained in the aforesaid spatial position determined with the profiling test) and, subsequently, impinges on the reflective diffraction grating 6 in the second angular position. This brings about, for each second light beam 60', the generation of a second zero-order diffracted beam 63 and a second first-order diffracted beam 64.

Each second first-order diffracted beam 64 is reflected towards the mirror 10 (arrow pointing towards the mirror) and is then reflected back towards the reflective diffraction grating 6 (return arrow pointing towards the grating), with an angle of incidence such that, after the reflection, it does not impinge on (e.g., it gets lost in the air) the second face of the gain chip 99.

This operating condition, defined as the ASE condition, is possible to thanks to the orientation of the reflective diffraction grating 6 in the second angular position, which causes the opening of the aforesaid external laser cavity.

Each second zero-order diffracted beam 63 is reflected towards the optical power measuring device 12 in order to measure a respective second value of optical power thereof. The second values of optical power are subsequently acquired by the command-and-control unit 80 (via the communication line C), which associates them with the respective second value of supply current, resulting in a second plurality of pairs of second values of supply current and of optical power.

The second plurality of pairs of second values of supply current and of optical power is subsequently transmitted by the command-and-control unit 80 to the processing unit 90 (via the communication line M). The second step of the method concludes with this action.

By way of example, the aforesaid first and second steps are carried out while maintaining (via the thermostat 20 commanded by the command-and-control unit via the communication line D) the gain chip 99 at a first temperature, for example equal to 23°C. Subsequently, the first and second steps described above are preferably repeated, maintaining the gain chip 99 at (at least) a second temperature greater than the first temperature by at least 4°C, and for example equal to 28°C.

In this manner one obtains a further first plurality of pairs of first values of supply current and of optical power and a further second plurality of pairs of second values of supply current and of optical power.

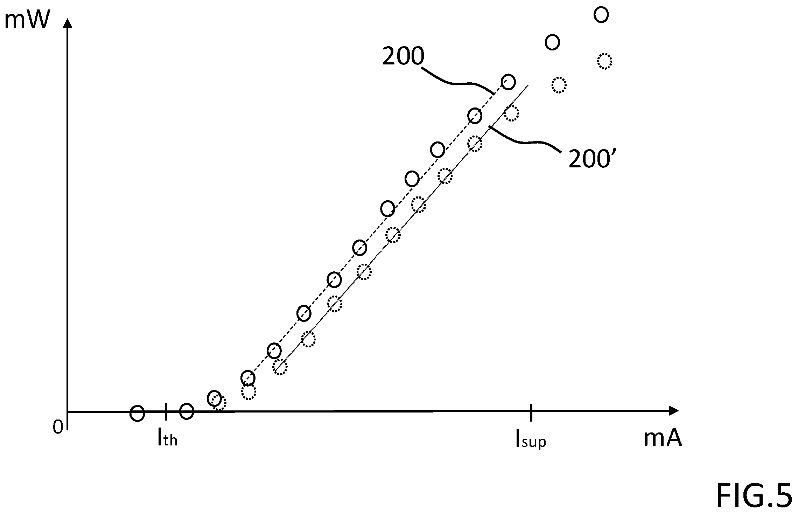

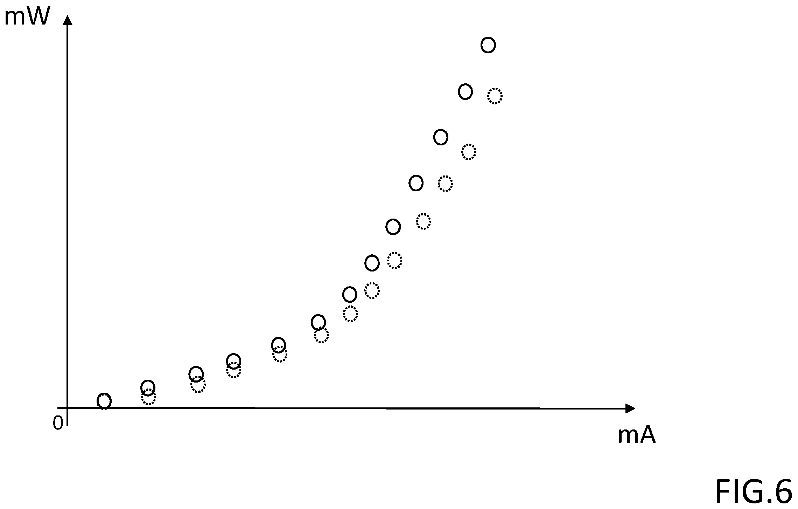

Figures 5 and 6 graphically show a purely illustrative example of pairs of values of optical power and supply current obtained respectively in the first step of the method and in the second step of the method, at two different temperature values of the gain chip (solid and dashed circles). In figure 5, for current values below the threshold current $I_{th}$ of the gain chip, equal, for example, to 50 mA, the values of optical power are negligible (non-lasing condition).

At this point, once all the aforesaid (e.g., four) pluralities of pairs of values of supply current and of optical power have been acquired, the processing unit 90 carries out the following operations.

In one embodiment, the operations described below for one of the four pluralities of pairs of values can be carried out immediately after the acquisition of the respective plurality of pairs of values, and before obtaining one of the other pluralities of pairs of values.

By way of example, the processing unit 90 determines a respective first linear function which interpolates, respectively, the first and the further first plurality of pairs of first values of supply current and of optical power (i.e., acquired under the lasing operating condition). One example of such linear functions is shown in figure 5, where the reference number 200 indicates the linear function which interpolates the first plurality of pairs, and the reference number 200' indicates the linear function which interpolates the further first plurality of pairs (in the zone of linearity of the curve). These interpolations are, by way of example, carried out for current values above the threshold current of the gain chip (indicated purely schematically by the label $I_{th}$) and below an upper reference value (indicated purely schematically by the label $I_{sup}$)

At this point, the processing unit 90 calculates a respective differential quantum efficiency of the first gain chip 99 as a function of a first predetermined mathematical correlation, for example the following:

$$\eta_d = \frac{q}{h\nu} m$$

where $\eta_d$ is the differential quantum efficiency (dimensionless), $h$ is the Planck constant, $\nu$ is a photon frequency, for example calculated as the ratio between the value of the speed of light in a vacuum and the wavelength at which the gain peak of the gain chip occurs (this wavelength can be known for the given gain chip, e.g., provided by the gain chip manufacturer, or, alternatively, it is measurable by means of suitable experimental tests, e.g., spectroscopy), e.g., the wavelength is equal to 1064 nm, $q$ is the electron charge (in absolute value), and $m$ is a angular coefficient of the first (or respective first) linear function (expressed in Watts/Amperes).

For example, for the gain chip 99, $\eta_d$ is equal to about 0.047 at the first temperature (23°C) and equal to about 0.042 at the second temperature (28°C).

At this point, the processing unit 90 calculates a respective modal gain coefficient and a respective carrier density at transparency of the gain chip as a function of a second predetermined mathematical correlation, which for example is:

$$P_{opt} = \frac{n_{sp} h\nu v_g}{L} \frac{g_0 \ln\left(\frac{(\eta I)^{\frac{1}{3}}}{(qVC)^{\frac{1}{3}}N_o}\right)}{g_0 \ln\left(\frac{(\eta I)^{\frac{1}{3}}}{(qVC)^{\frac{1}{3}}N_o}\right) - \alpha_i} \left(e^{[L(g_0 \ln\left(\frac{(\eta I)^{\frac{1}{3}}}{(qVC)^{\frac{1}{3}}N_o}\right) - \alpha_i)} - 1\right)$$

where $P_{opt}$ is the optical power, $I$ is the supply current, $g_0$ is the modal gain coefficient (expressed in cm$^{-1}$), $N_o$ is the carrier density at transparency (expressed in cm$^{-3}$), $n_{sp}$ is a population inversion factor (e.g., equal to about 1), $h$ is the Planck constant, $\nu$ is the photon frequency, $v_g$ is a group velocity in the medium (i.e., the air), $L$ is a length of the gain chip 99 taken along a prevalent direction of extension of the gain chip 99 which goes from the first to the second face, $\alpha_i$ represents the internal losses of the gain chip (equal, for example, to 15 cm$^{-1}$; such internal losses are for example determined experimentally, or estimated as a function of the material of the gain chip, or known, e.g., provided by the manufacturer), $\eta$ is an injection efficiency (equal, for example, to about 0.5, and for example determined experimentally, or estimated as a function of the material of the gain chip), C is the Auger recombination coefficient (equal, for example, to about 10$^{-28}$ cm$^6$ s$^{-1}$), $V$ is a volume of the gain chip 99, and $q$ is the electron charge.

For example, for the first gain chip 99, $g_0$ is equal to about 63 cm$^{-1}$ at the first temperature (23°C) and equal to about 68 cm$^{-1}$ at the second temperature (28°C), and $N_o$ is equal to about 8.89*10$^{17}$ cm$^{-3}$ at both the first and second temperatures.

At this point, the method envisages repeating (carrying out all the aforesaid operations, profiling test included) the calculation of the differential quantum efficiency, of the modal gain coefficient and of the carrier density at transparency for each of the other gain chips of the batch.

At this point it is possible to verify that the differential quantum efficiency, the modal gain coefficient, and the carrier density at transparency of a given gain chip satisfy a predetermined respective selection criterion, for example they are above/below a predetermined threshold value. Alternatively, or in addition, it is also possible to make a combined evaluation of the three parameters.

**Claims**

1. Method for characterizing a batch of gain chips, wherein each gain chip has a respective first face at least partially reflective and a respective second face at least partially transparent, wherein said method comprises carrying out the following operations on each gain chip of said batch:

    a) positioning said gain chip (99) with said respective second face facing towards a reflective diffraction grating (6); b1) orienting said reflective diffraction grating (6) in a first angular position;
    b2) supplying said gain chip (99) with a plurality of first values of supply current so that said gain chip (99) emits a respective first light beam (60) for each first value of supply current;
    b3) making impinge each first light beam (60) onto said reflective diffraction grating (6) in the first angular position so as to generate a respective first zero-order diffracted beam (61) and a respective first first-order diffracted beam (62), said respective first first-order diffracted beam (62) entering said gain chip (99) through said second face;
    b4) measuring a respective first value of optical power of each first zero-order diffracted beam (61);
    b5) associating each first value of optical power to the respective first value of supply current;
    c) as a function of a plurality of pairs of first values of supply current and of optical power and as a function of a first predetermined mathematical correlation, calculating a respective differential quantum efficiency;
    d1) orienting said reflective diffraction grating (6) in a second angular position;
    d2) supplying said gain chip (99) with a plurality of second values of supply current so that said gain chip (99) emits a respective second light beam (60') for each second value of supply current;
    d3) making impinge each second light beam (60') onto said reflective diffraction grating (6) in the second angular position so as to generate a respective second zero-order diffracted beam (63) and a respective second first-order diffracted beam (64), said respective second first-order diffracted beam (64) not entering said gain chip (99);
    d4) measuring a respective second value of optical power of each second zero-order diffracted beam (63);
    d5) associating each second value of optical power to the respective second value of supply current;
    e) as a function of a plurality of pairs of second values of supply current and of optical power and as a function of a second predetermined mathematical correlation, calculating a respective modal gain coefficient and a respective carrier density at transparency;
    n) verifying that said respective differential quantum efficiency, said respective modal gain coefficient and said respective carrier density at transparency satisfy a respective predetermined selection criterion.

2. Method according to claim 1, wherein said operation c) comprises determining a first linear function that interpolates said plurality of pairs of first values of supply current and of optical power, and wherein said first predetermined mathematical correlation is:

$$\eta_d = \frac{q}{h\nu}\, m$$

wherein $\eta_d$ is said differential quantum efficiency, $h$ is the Planck constant, $\nu$ is a photon frequency, $q$ is the electronic charge, and $m$ is a slope of said first linear function.

3. Method according to any one of the preceding claims, wherein said second predetermined mathematical correlation is:

$$P_{opt} = \frac{n_{sp} h \nu v_g}{L} \frac{g_0 \ln\left(\frac{(\eta I)^{\frac{1}{3}}}{(qVC)^{\frac{1}{3}} N_o}\right)}{g_0 \ln\left(\frac{(\eta I)^{\frac{1}{3}}}{(qVC)^{\frac{1}{3}} N_o}\right) - \alpha_i} \left(e^{[L(g_0 \ln\left(\frac{(\eta I)^{\frac{1}{3}}}{(qVC)^{\frac{1}{3}} N_o}\right) - \alpha_i)} - 1\right)$$

wherein $P_{opt}$ is said optical power, $I$ is said supply current, $g_0$ is said modal gain coefficient, $N_o$ is said carrier density at transparency, $n_{sp}$ is a population inversion factor, $h$ is the Planck constant, $v$ is a photon frequency, $v_g$ is a group velocity, $L$ is a length of said gain chip (99), $\alpha_i$ represents internal losses of said gain chip (99), $\eta$ is an injection efficiency, $C$ is the Auger recombination coefficient, $V$ is a volume of said gain chip (99), $q$ is the electronic charge

4. Method according to any one of the preceding claims, comprising:

- before said operations b3) and d3), collimating said first (60) and said second light beam (60');
- during said operations from b2) to b4) and said operations from d2) to d4), maintaining said gain chip (99) at a first temperature;
- repeating said operations from b2) to b5), and from d2) to d5), while maintaining said gain chip at a second temperature, and repeating said operations c), e) and n),

wherein a difference in absolute value between said first and second temperature is at least equal to 4°C.

5. Method according to any one of the preceding claims, comprising before said operations b1) and d1):

- positioning said reflective diffraction grating (6) in a non-operative position in which said reflective diffraction grating (6) does not intercept said light beams (60, 60');
- supplying said gain chip (99) with a test value of supply current so that said gain chip (99) emits a test light beam (70);
- collimating said test light beam (70) for obtaining a collimated test light beam (71);
- measuring a profile of said collimated test light beam (71);
- verifying that said profile satisfies a predetermined profiling criterion.

6. Method according to any one of the preceding claims, wherein said verifying comprises ordering said gain chips of said batch according to a progressive order of one or more of said respective differential quantum efficiency, said respective modal gain coefficient and said respective carrier density at transparency, wherein said respective predetermined selection criterion comprises a respective predetermined threshold value,
and/or
wherein said verifying comprises:

- as a function of said respective differential quantum efficiency, said respective modal gain coefficient and said respective carrier density at transparency of each gain chip, determining a respective statistical set for each of said differential quantum efficiency, said modal gain coefficient and said carrier density at transparency;
- identifying a gain chip whose respective differential quantum efficiency, whose respective modal gain coefficient and/or whose respective carrier density at transparency represent an outlier in the respective statistical set.

7. System (100) for characterizing a batch of gain chips, wherein each gain chip has a respective first face at least partially reflective and a respective second face at least partially transparent, wherein said system (100) for characterizing comprises:

- a test bench (1) comprising:

i) a positioning device (2) for a gain chip (99);
ii) a supply source (3) structured to supply a supply current to said gain chip (99) positioned in the positioning device (2) so that said gain chip (99) emits a light beam (60, 60');
iii) a reflective diffraction grating (6) structured

such that said light beam (60, 60') incident onto said reflective diffraction grating

(6) generates a respective zero-order diffracted beam (61, 63) and a respective first-order diffracted beam (62, 64);

iv) a first actuator (7) structured to orient said reflective diffraction grating (6) alternatively between a first angular position in which said first-order diffracted beam (62) enters said gain chip (99) through said second face, and a second angular position in which said first-order diffracted beam (64) does not enter said gain chip;

v) an optical power measuring device (12) structured to measure an optical power of said zero-order diffracted beam (61, 63);

vi) a command-and-control unit (80) operatively connected to said supply source (3), said first actuator (7) and said measuring device (12),

 - a processing unit (90) connected to said command-and-control unit (80),

wherein said command-and-control unit (80) is programmed and configured to carry out the following operations, with said gain chip (99) positioned in the positioning device (2) with said second face facing towards said reflective diffraction grating (6):

f1) commanding said first actuator (7) for orienting said reflective diffraction grating (6) in said first angular position;

f2) commanding said supply source (3) to supply said gain chip (99) with a plurality of first values of said supply current so that said gain chip (99) emits a respective first light beam (60) for each first value of supply current, said respective first light beam (60) generating a respective first zero-order diffracted beam (61) and a respective first first-order diffracted beam (62);

f3) receiving from said optical power measuring device (12) a respective first value of optical power of each first zero-order diffracted beam (61);

f4) associating each first value of optical power to the respective first value of supply current;

g1) commanding said first actuator (7) to orient said reflective diffraction grating (6) in said second angular position;

g2) commanding said supply source (3) to supply said gain chip (99) with a plurality of second values of supply current so that said gain chip (99) emits a respective second light beam (60') for each second value of supply current, said respective second light beam (60') generating a respective second zero-order diffracted beam (63) and a respective second first-order diffracted beam (64);

g3) receiving from said optical power measuring device (12) a respective second value of optical power of each second zero-order diffracted beam (63);

g4) associating each second value of optical power to the respective second value of supply current,

and wherein said processing unit (90) is programmed and configured to carry out the following operations:

i1) receiving from said command-and-control unit (80) a first plurality of pairs of first values of supply current and of optical power;

i2) as a function of said first plurality and as a function of a first predetermined mathematical correlation, calculating a respective differential quantum efficiency;

m1) receiving from said command-and-control unit (80) a second plurality of pairs of second values of supply current and of optical power;

m2) as a function of said second plurality and as a function of a second predetermined mathematical correlation, calculating a respective modal gain coefficient and a respective carrier density at transparency;

n) verifying that said respective differential quantum efficiency, said respective modal gain coefficient and said respective carrier density at transparency satisfy a respective predetermined selection criterion.

8.  System (100) according to claim 7, wherein said test bench (1) comprises a thermostat (20) structured to maintain said gain chip (99), positioned in said positioning device (2), stable in temperature, wherein said command-and-control unit (80) is operatively connected to said thermostat (20) and is programmed and configured to:

 - during said operations f2), f3) and g2), g3), command said thermostat (20) to maintain said gain chip (99) at a first temperature;
 - repeat at least said operations from f2) to f4) and said operations from g2) to g4) while maintaining said gain chip (99) at a second temperature, wherein a difference in absolute value between said first and second temperature is at least equal to 4°C,

and wherein said processing unit (90) is programmed and configured to repeat said operations i1), i2), m1), m2), and n).

9. System (100) according to claim 7 or 8, wherein said test bench (1) comprises:

- a collimating lens (4) interposed between said positioning device (2) and said reflective diffraction grating (6) and structured to collimate said first (60) and said second light beam (60');
- a second multi-axis actuator (5) structured to move said collimating lens (4) in space;
- a light beam profiler (9) aligned with said positioning device (2) and structured to measure a profile of a light beam;
- a mechanical arm (8) structured to move said reflective diffraction grating (6) between an operative position, and a non-operative position in which said reflective diffraction grating (6) does not intercept said light beams (60, 60').

10. System (100) according to claim 9, wherein said command-and-control unit (80) is operatively connected to said light beam profiler (9), to said second actuator (5), and to said mechanical arm (8), wherein said command-and-control unit (80) is programmed and configured to, preliminarily:

- command said mechanical arm (8) to position said reflective diffraction grating (6) in said non-operative position;
- command said second actuator (5) to position said collimating lens (4) in space;
- command said supply source (3) to supply said gain chip (99) with a test value of supply current so that said gain chip (99) emits a test light beam (70) which is collimated through said collimating lens (4) to obtain a collimated test light beam (71);
- receive from said light beam profiler (9) a measure of a profile of said collimated test light beam (71),

and wherein said processing unit (90) is programmed and configured to receive from said command-and-control unit (80) said profile of said collimated test light beam (71) and verifying that said profile satisfies a predetermined profiling criterion.

**Patentansprüche**

1. Verfahren zum Charakterisieren einer Charge von Gain-Chips, wobei jeder Gain-Chip eine jeweilige erste Fläche aufweist, die zumindest teilweise reflektierend ist, und eine jeweilige zweite Fläche aufweist, die zumindest teilweise transparent ist, wobei said Verfahren umfasst, die folgenden Operationen an jedem Gain-Chip said Charge auszuführen:

a) Positionieren said Gain-Chip (99) mit said jeweiliger zweiter Fläche, die zu einem reflektierenden Beugungsgitter (6) hin ausgerichtet ist;

b1) Ausrichten said reflektierendes Beugungsgitter (6) in einer ersten Winkelposition;

b2) Versorgen said Gain-Chip (99) mit einer Vielzahl von ersten Werten von Versorgungsstrom, sodass said Gain-Chip (99) einen jeweiligen ersten Lichtstrahl (60) für jeden ersten Wert von Versorgungsstrom emittiert;

b3) Auftreffenlassen jedes ersten Lichtstrahls (60) auf said reflektierendes Beugungsgitter (6) in der ersten Winkelposition, um einen jeweiligen ersten nullten Beugungsstrahl (61) und einen jeweiligen ersten ersten Beugungsstrahl (62) zu erzeugen, wobei said jeweiliger erster erster Beugungsstrahl (62) said Gain-Chip (99) durch said zweite Fläche eintritt;

b4) Messen eines jeweiligen ersten Werts der optischen Leistung jedes ersten nullten Beugungsstrahls (61);

b5) Zuordnen jedes ersten Werts der optischen Leistung zu dem jeweiligen ersten Wert des Versorgungsstroms;

c) als Funktion einer Vielzahl von Paaren von ersten Werten von Versorgungsstrom und von optischer Leistung und als Funktion einer ersten vorbestimmten mathematischen Korrelation, Berechnen einer jeweiligen differentiellen Quanteneffizienz;

d1) Ausrichten said reflektierendes Beugungsgitter (6) in einer zweiten Winkelposition;

d2) Versorgen said Gain-Chip (99) mit einer Vielzahl von zweiten Werten von Versorgungsstrom, sodass said Gain-Chip (99) einen jeweiligen zweiten Lichtstrahl (60') für jeden zweiten Wert von Versorgungsstrom emittiert;

d3) Auftreffenlassen jedes zweiten Lichtstrahls (60') auf said reflektierendes Beugungsgitter (6) in der zweiten Winkelposition, um einen jeweiligen zweiten nullten Beugungsstrahl (63) und einen jeweiligen zweiten ersten Beugungsstrahl (64) zu erzeugen, wobei said jeweiliger zweiter erster Beugungsstrahl (64) nicht in said Gain-Chip (99) eintritt;

d4) Messen eines jeweiligen zweiten Werts der optischen Leistung jedes zweiten nullten Beugungsstrahls (63);

d5) Zuordnen jedes zweiten Werts der optischen Leistung zu dem jeweiligen zweiten Wert des Versorgungsstroms;

e) als Funktion einer Vielzahl von Paaren von zweiten Werten von Versorgungsstrom und von optischer Leistung und als Funktion einer zweiten vorbestimmten mathematischen Korrelation, Berechnen eines jeweiligen modalen Verstärkungskoeffizienten und einer jeweiligen Trägerdichte bei Transparenz;

n) Verifizieren, dass said jeweilige differentielle Quanteneffizienz, said jeweilige modale Verstärkungskoeffizient und said jeweilige Trägerdichte bei Transparenz ein jeweiliges vorbestimmtes Auswahlkriterium erfüllen.

2. Verfahren nach Anspruch 1, wobei said Operation c) umfasst, eine erste lineare Funktion zu bestimmen, die said Vielzahl von Paaren von ersten Werten von Versorgungsstrom und von optischer Leistung interpoliert, und wobei said erste vorbestimmte mathematische Korrelation ist:

$$\eta_d = \frac{q}{hv} m$$

wobei $\eta_d$ said differentielle Quanteneffizienz ist, $h$ die Planck-Konstante ist, $v$ eine Photonfrequenz ist, $q$ die elektrische Ladung ist, und $m$ eine Steigung said erste lineare Funktion ist.

3. Verfahren nach einem der vorhergehenden Ansprüche, wobei said zweite vorbestimmte mathematische Korrelation ist:

$$P_{opt} = \frac{n_{sp} h v\, v_g}{L} \frac{g_0 \ln(\frac{(\eta I)^{\frac{1}{3}}}{(qVC)^{\frac{1}{3}} N_o})}{g_0 \ln(\frac{(\eta I)^{\frac{1}{3}}}{(qVC)^{\frac{1}{3}} N_o}) - \alpha_i} (e^{[L(g_0 \ln(\frac{(\eta I)^{\frac{1}{3}}}{(qVC)^{\frac{1}{3}} N_o}) - \alpha_i)]} - 1)$$

wobei $P_{opt}$ said optische Leistung ist, $I$ said Versorgungsstrom ist, $g_0$ said modale Verstärkungskoeffizient ist, $N_o$ said Trägerdichte bei Transparenz ist, $n_{sp}$ ein Populationsinversionsfaktor ist, $h$ die Planck-Konstante ist, $v$ eine Photonfrequenz ist, $v_g$ eine Gruppengeschwindigkeit ist, $L$ eine Länge said Gain-Chip (99) ist, $\alpha_i$ interne Verluste said Gain-Chip (99) repräsentiert, $\eta$ eine Injektionseffizienz ist, $C$ der Auger-Rekombinationskoeffizient ist, $V$ ein Volumen said Gain-Chip (99) ist, $q$ die elektrische Ladung ist.

4. Verfahren nach einem der vorhergehenden Ansprüche, umfassend:

   - vor said Operationen b3) und d3), Kollimieren said erster (60) und said zweiter Lichtstrahl (60');
   - während said Operationen von b2) bis b4) und said Operationen von d2) bis d4), Halten said Gain-Chip (99) bei einer ersten Temperatur;
   - Wiederholen said Operationen von b2) bis b5), und von d2) bis d5), während said Gain-Chip bei einer zweiten Temperatur gehalten wird, und Wiederholen said Operationen c), e) und n), wobei eine Differenz im Absolutwert zwischen said erster und said zweiter Temperatur mindestens gleich 4°C ist.

5. Verfahren nach einem der vorhergehenden Ansprüche, umfassend vor said Operationen b1) und d1):

   - Positionieren said reflektierendes Beugungsgitter (6) in einer nicht-operativen Position, in welcher said reflektierendes Beugungsgitter (6) said Lichtstrahlen (60, 60') nicht abfängt;
   - Versorgen said Gain-Chip (99) mit einem Testwert von Versorgungsstrom, sodass said Gain-Chip (99) einen Testlichtstrahl (70) emittiert;
   - Kollimieren said Testlichtstrahl (70), um einen kollimierten Testlichtstrahl (71) zu erhalten;
   - Messen eines Profils said kollimierter Testlichtstrahl (71);
   - Verifizieren, dass said Profil ein vorbestimmtes Profilierungskriterium erfüllt.

6. Verfahren nach einem der vorhergehenden Ansprüche, wobei said Verifizieren umfasst, Ordnen said Gain-Chips said Charge gemäß einer fortschreitenden Reihenfolge eines oder mehrerer von said jeweilige differentielle Quanteneffizienz, said jeweilige modale Verstärkungskoeffizient und said jeweilige Trägerdichte bei Transparenz, wobei said jeweiliges vorbestimmtes Auswahlkriterium einen jeweiligen vorbestimmten Schwellenwert umfasst, und/oder wobei said Verifizieren umfasst:

- als Funktion said jeweilige differentielle Quanteneffizienz, said jeweilige modale Verstärkungskoeffizient und said jeweilige Trägerdichte bei Transparenz jedes Gain-Chip, Bestimmen eines jeweiligen statistischen Satzes für jede von said differentielle Quanteneffizienz, said modale Verstärkungskoeffizient und said Trägerdichte bei Transparenz;

- Identifizieren eines Gain-Chip, dessen said jeweilige differentielle Quanteneffizienz, dessen said jeweilige modale Verstärkungskoeffizient und/oder dessen said jeweilige Trägerdichte bei Transparenz einen Ausreißer in dem jeweiligen statistischen Satz darstellt.

7. System (100) zum Charakterisieren einer Charge von Gain-Chips, wobei jeder Gain-Chip eine jeweilige erste Fläche aufweist, die zumindest teilweise reflektierend ist, und eine jeweilige zweite Fläche aufweist, die zumindest teilweise transparent ist, wobei said System (100) zum Charakterisieren umfasst:

- einen Prüfstand (1), umfassend:

i) eine Positioniervorrichtung (2) für einen Gain-Chip (99);
ii) eine Versorgungsquelle (3), die strukturiert ist, einen Versorgungsstrom zu said Gain-Chip (99), positioniert in said Positioniervorrichtung (2), zu liefern, sodass said Gain-Chip (99) einen Lichtstrahl (60, 60') emittiert;
iii) ein reflektierendes Beugungsgitter (6), strukturiert derart, dass said Lichtstrahl (60, 60') einfallend auf said reflektierendes Beugungsgitter (6) einen jeweiligen nullten Beugungsstrahl (61, 63) und einen jeweiligen ersten Beugungsstrahl (62, 64) erzeugt;
iv) einen ersten Aktuator (7), strukturiert, said reflektierendes Beugungsgitter (6) alternativ zwischen einer ersten Winkelposition, in welcher said erster Beugungsstrahl (62) said Gain-Chip (99) durch said zweite Fläche eintritt, und einer zweiten Winkelposition, in welcher said erster Beugungsstrahl (64) nicht in said Gain-Chip eintritt, auszurichten;
v) eine optische Leistungsmesseinrichtung (12), strukturiert, eine optische Leistung said nullter Beugungsstrahl (61, 63) zu messen;
vi) eine Befehls- und Steuereinheit (80), operativ verbunden mit said Versorgungsquelle (3), said erster Aktuator (7) und said Messeinrichtung (12),

- eine Verarbeitungseinheit (90), verbunden mit said Befehls- und Steuereinheit (80), wobei said Befehls- und Steuereinheit (80) programmiert und konfiguriert ist, die folgenden Operationen auszuführen, mit said Gain-Chip (99), positioniert in said Positioniervorrichtung (2) mit said zweite Fläche zu said reflektierendes Beugungsgitter (6) hin ausgerichtet:

f1) Befehlen said erster Aktuator (7) zum Ausrichten said reflektierendes Beugungsgitter (6) in said erster Winkelposition;
f2) Befehlen said Versorgungsquelle (3), said Gain-Chip (99) mit einer Vielzahl von ersten Werten von said Versorgungsstrom zu versorgen, sodass said Gain-Chip (99) einen jeweiligen ersten Lichtstrahl (60) emittiert;
f3) Empfangen von said optische Leistungsmesseinrichtung (12) eines jeweiligen ersten Werts der optischen Leistung jedes ersten nullten Beugungsstrahl (61);
f4) Zuordnen jedes ersten Werts der optischen Leistung zu dem jeweiligen ersten Wert von Versorgungsstrom;
g1) Befehlen said erster Aktuator (7), said reflektierendes Beugungsgitter (6) in said zweiter Winkelposition auszurichten;
g2) Befehlen said Versorgungsquelle (3), said Gain-Chip (99) mit einer Vielzahl von zweiten Werten von Versorgungsstrom zu versorgen;
g3) Empfangen von said optische Leistungsmesseinrichtung (12) eines jeweiligen zweiten Werts der optischen Leistung jedes zweiten nullten Beugungsstrahl (63);
g4) Zuordnen jedes zweiten Werts der optischen Leistung zu dem jeweiligen zweiten Wert von Versorgungsstrom, und wobei said Verarbeitungseinheit (90) programmiert und konfiguriert ist, die folgenden Operationen auszuführen:
i1) Empfangen von said Befehls- und Steuereinheit (80) einer ersten Vielzahl von Paaren;
i2) Berechnen said differentielle Quanteneffizienz;
m1) Empfangen einer zweiten Vielzahl;
m2) Berechnen said modale Verstärkungskoeffizient und said Trägerdichte bei Transparenz;
n) Verifizieren, dass said Parameter said Kriterium erfüllen.

8. System (100) nach Anspruch 7, wobei said Prüfstand (1) einen Thermostat (20) umfasst, der strukturiert ist, said Gain-Chip (99), positioniert in said Positioniervorrichtung (2), temperaturstabil zu halten, wobei said Befehls- und Steuereinheit (80) operativ mit said Thermostat (20) verbunden ist und programmiert und konfiguriert ist:

   - während said Operationen f2), f3) und g2), g3), said Thermostat (20) zu befehlen, said Gain-Chip (99) bei einer ersten Temperatur zu halten;
   - zumindest said Operationen von f2) bis f4) und said Operationen von g2) bis g4) zu wiederholen, während said Gain-Chip (99) bei einer zweiten Temperatur gehalten wird, wobei eine Differenz im Absolutwert zwischen said erster und said zweiter Temperatur mindestens gleich 4°C ist,

   und wobei said Verarbeitungseinheit (90) programmiert und konfiguriert ist, said Operationen i1), i2), m1), m2) und n) zu wiederholen.

9. System (100) nach Anspruch 7 oder 8, wobei said Prüfstand (1) umfasst:

   - eine Kollimationslinse (4), angeordnet zwischen said Positioniervorrichtung (2) und said reflektierendes Beugungsgitter (6) und strukturiert, said erster (60) und said zweiter Lichtstrahl (60') zu kollimieren;
   - einen zweiten Mehrachsen-Aktuator (5), strukturiert, said Kollimationslinse (4) im Raum zu bewegen;
   - einen Lichtstrahl-Profiler (9), ausgerichtet mit said Positioniervorrichtung (2) und strukturiert, ein Profil eines Lichtstrahls zu messen;
   - einen mechanischen Arm (8), strukturiert, said reflektierendes Beugungsgitter (6) zwischen einer operativen Position und einer nicht-operativen Position zu bewegen, in welcher said reflektierendes Beugungsgitter (6) said Lichtstrahlen (60, 60') nicht abfängt.

10. System (100) nach Anspruch 9, wobei said Befehls- und Steuereinheit (80) operativ mit said Lichtstrahl-Profiler (9), mit said zweiter Aktuator (5) und mit said mechanischer Arm (8) verbunden ist, wobei said Befehls- und Steuereinheit (80) programmiert und konfiguriert ist, vorläufig:

   - said mechanischer Arm (8) zu befehlen, said reflektierendes Beugungsgitter (6) in said nicht-operative Position zu positionieren;
   - said zweiter Aktuator (5) zu befehlen, said Kollimationslinse (4) im Raum zu positionieren;
   - said Versorgungsquelle (3) zu befehlen, said Gain-Chip (99) mit einem Testwert von Versorgungsstrom zu versorgen, sodass said Gain-Chip (99) einen Testlichtstrahl (70) emittiert, welcher durch said Kollimationslinse (4) kollimiert wird, um einen kollimierten Testlichtstrahl (71) zu erhalten;
   - von said Lichtstrahl-Profiler (9) eine Messung eines Profils said kollimierter Testlichtstrahl (71) zu empfangen, und wobei said Verarbeitungseinheit (90) programmiert und konfiguriert ist, von said Befehls- und Steuereinheit (80) said Profil said kollimierter Testlichtstrahl (71) zu empfangen und zu verifizieren, dass said Profil ein vorbestimmtes Profilierungskriterium erfüllt.

## Revendications

1. Procédé pour caractériser un lot de puces de gain, dans lequel chaque puce de gain présente une face première respective au moins partiellement réfléchissante et une face seconde respective au moins partiellement transparente, dans lequel ledit procédé comprend exécuter les opérations suivantes sur chaque puce de gain dudit lot :

   a) positionner ladite puce de gain (99) avec ladite face seconde respective faisant face vers un réseau de diffraction réfléchissant (6) ;
   b1) orienter ledit réseau de diffraction réfléchissant (6) dans une première position angulaire ;
   b2) alimenter ladite puce de gain (99) avec une pluralité de premières valeurs de courant d'alimentation de sorte que ladite puce de gain (99) émette un faisceau lumineux premier respectif (60) pour chaque première valeur de courant d'alimentation ;
   b3) faire impacter chaque faisceau lumineux premier (60) sur ledit réseau de diffraction réfléchissant (6) dans la première position angulaire de manière à générer un faisceau diffracté d'ordre zéro premier respectif (61) et un faisceau diffracté d'ordre premier premier respectif (62), ledit faisceau diffracté d'ordre premier premier respectif (62) entrant dans ladite puce de gain (99) à travers ladite face seconde ;
   b4) mesurer une valeur première respective de puissance optique de chaque faisceau diffracté d'ordre zéro premier (61) ;

b5) associer chaque valeur première de puissance optique à la valeur première respective de courant d'alimentation ;

c) en fonction d'une pluralité de paires de valeurs premières de courant d'alimentation et de puissance optique et en fonction d'une première corrélation mathématique prédéterminée, calculer une efficacité quantique différentielle respective ;

d1) orienter ledit réseau de diffraction réfléchissant (6) dans une seconde position angulaire ;

d2) alimenter ladite puce de gain (99) avec une pluralité de secondes valeurs de courant d'alimentation de sorte que ladite puce de gain (99) émette un faisceau lumineux second respectif (60') pour chaque seconde valeur de courant d'alimentation ;

d3) faire impacter chaque faisceau lumineux second (60') sur ledit réseau de diffraction réfléchissant (6) dans la seconde position angulaire de manière à générer un faisceau diffracté d'ordre zéro second respectif (63) et un faisceau diffracté d'ordre premier second respectif (64), ledit faisceau diffracté d'ordre premier second respectif (64) n'entrant pas dans ladite puce de gain (99) ;

d4) mesurer une valeur seconde respective de puissance optique de chaque faisceau diffracté d'ordre zéro second (63) ;

d5) associer chaque valeur seconde de puissance optique à la valeur seconde respective de courant d'alimentation ;

e) en fonction d'une pluralité de paires de valeurs secondes de courant d'alimentation et de puissance optique et en fonction d'une seconde corrélation mathématique prédéterminée, calculer un coefficient de gain modal respectif et une densité de porteurs à transparence respective ;

n) vérifier que ladite efficacité quantique différentielle respective, ledit coefficient de gain modal respectif et ladite densité de porteurs à transparence respective satisfont un critère de sélection prédéterminé respectif.

2. Procédé selon la revendication 1, dans lequel ladite opération c) comprend déterminer une première fonction linéaire qui interpole ladite pluralité de paires de valeurs premières de courant d'alimentation et de puissance optique, et dans lequel ladite première corrélation mathématique prédéterminée est :

$$\eta_d = \frac{q}{h\nu}m$$

dans lequel $\eta_d$ est ladite efficacité quantique différentielle, $h$ est la constante de Planck, $\nu$ est une fréquence de photon, $q$ est la charge électronique, et $m$ est une pente de ladite première fonction linéaire.

3. Procédé selon une quelconque des revendications précédentes, dans lequel ladite seconde corrélation mathématique prédéterminée est :

$$P_{opt} = \frac{n_{sp}h\nu v_g}{L} \frac{g_0 \ln\left(\frac{(\eta I)^{\frac{1}{3}}}{(qVC)^{\frac{1}{3}}N_o}\right)}{g_0 \ln\left(\frac{(\eta I)^{\frac{1}{3}}}{(qVC)^{\frac{1}{3}}N_o}\right) - \alpha_i} \left(e^{\left[L\left(g_0 \ln\left(\frac{(\eta I)^{\frac{1}{3}}}{(qVC)^{\frac{1}{3}}N_o}\right) - \alpha_i\right)\right]} - 1\right)$$

dans lequel $P_{opt}$ est ladite puissance optique, $I$ est ledit courant d'alimentation, $g_0$ est ledit coefficient de gain modal, $N_o$ est ladite densité de porteurs à la transparence, $n_{sp}$ est un facteur d'inversion de population, $h$ est la constante de Planck, $\nu$ est une fréquence de photon, $v_g$ est une vitesse de groupe, $L$ est une longueur de ladite puce de gain (99), $\alpha_i$ représente des pertes internes de ladite puce de gain (99), $\eta$ est une efficacité d'injection, $C$ est le coefficient de recombinaison Auger, $V$ est un volume de ladite puce de gain (99), $q$ est la charge électronique.

4. Procédé selon une quelconque des revendications précédentes, comprenant :

- avant lesdites opérations b3) et d3), collimater ledit faisceau lumineux premier (60) et ledit faisceau lumineux second (60') ;
- pendant lesdites opérations de b2) à b4) et lesdites opérations de d2) à d4), maintenir ladite puce de gain (99) à une première température ;
- répéter lesdites opérations de b2) à b5), et de d2) à d5), tout en maintenant ladite puce de gain à une seconde température, et répéter lesdites opérations c), e) et n), dans lequel une différence en valeur absolue entre ladite première température et ladite seconde température est au moins égale à 4°C.

5. Procédé selon une quelconque des revendications précédentes, comprenant avant lesdites opérations b1) et d1) :

- positionner ledit réseau de diffraction réfléchissant (6) dans une position non opérative dans laquelle ledit réseau de diffraction réfléchissant (6) n'intercepte pas lesdits faisceaux lumineux (60, 60') ;
- alimenter ladite puce de gain (99) avec une valeur de test de courant d'alimentation de sorte que ladite puce de gain (99) émette un faisceau lumineux de test (70) ;
- collimater ledit faisceau lumineux de test (70) pour obtenir un faisceau lumineux de test collimaté (71) ;
- mesurer un profil dudit faisceau lumineux de test collimaté (71) ;
- vérifier que ledit profil satisfait un critère de profilage prédéterminé.

6. Procédé selon une quelconque des revendications précédentes, dans lequel ladite vérification comprend ordonner lesdites puces de gain dudit lot selon un ordre progressif d'une ou plusieurs parmi ladite efficacité quantique différentielle respective, ledit coefficient de gain modal respectif et ladite densité de porteurs à transparence respective, dans lequel ledit critère de sélection prédéterminé respectif comprend une valeur seuil prédéterminée respective, et/ou
dans lequel ladite vérification comprend :

- en fonction de ladite efficacité quantique différentielle respective, dudit coefficient de gain modal respectif et de ladite densité de porteurs à transparence respective de chaque puce de gain, déterminer un ensemble statistique respectif pour chacune parmi ladite efficacité quantique différentielle, ledit coefficient de gain modal et ladite densité de porteurs à transparence ;
- identifier une puce de gain dont ladite efficacité quantique différentielle respective, dont ledit coefficient de gain modal respectif et/ou dont ladite densité de porteurs à transparence respective représentent une valeur aberrante dans l'ensemble statistique respectif.

7. Système (100) pour caractériser un lot de puces de gain, dans lequel chaque puce de gain présente une face première respective au moins partiellement réfléchissante et une face seconde respective au moins partiellement transparente, dans lequel ledit système (100) pour caractériser comprend :

- un banc d'essai (1) comprenant :

i) un dispositif de positionnement (2) pour une puce de gain (99) ;
ii) une source d'alimentation (3) configurée pour fournir un courant d'alimentation à ladite puce de gain (99) positionnée dans le dispositif de positionnement (2) de sorte que ladite puce de gain (99) émette un faisceau lumineux (60, 60') ;
iii) un réseau de diffraction réfléchissant (6) configuré de sorte que ledit faisceau lumineux (60, 60') incident sur ledit réseau de diffraction réfléchissant (6) génère un faisceau diffracté d'ordre zéro respectif (61, 63) et un faisceau diffracté d'ordre premier respectif (62, 64) ;
iv) un premier actionneur (7) configuré pour orienter ledit réseau de diffraction réfléchissant (6) alternativement entre une première position angulaire dans laquelle ledit faisceau diffracté d'ordre premier (62) entre dans ladite puce de gain (99) à travers ladite face seconde, et une seconde position angulaire dans laquelle ledit faisceau diffracté d'ordre premier (64) n'entre pas dans ladite puce de gain ;
v) un dispositif de mesure de puissance optique (12) configuré pour mesurer une puissance optique dudit faisceau diffracté d'ordre zéro (61, 63) ;
vi) une unité de commande et de contrôle (80) connectée de manière opérative à ladite source d'alimentation (3), audit premier actionneur (7) et audit dispositif de mesure (12),

- une unité de traitement (90) connectée à ladite unité de commande et de contrôle (80), dans lequel ladite unité de commande et de contrôle (80) est programmée et configurée pour exécuter les opérations suivantes, avec ladite puce de gain (99) positionnée dans le dispositif de positionnement (2) avec ladite face seconde faisant face vers ledit réseau de diffraction réfléchissant (6) :

f1) commander ledit premier actionneur (7) pour orienter ledit réseau de diffraction réfléchissant (6) dans ladite première position angulaire ;
f2) commander ladite source d'alimentation (3) pour alimenter ladite puce de gain (99) avec une pluralité de valeurs premières dudit courant d'alimentation de sorte que ladite puce de gain (99) émette un faisceau lumineux premier respectif (60) pour chaque valeur première de courant d'alimentation, ledit faisceau lumineux premier respectif (60) générant un faisceau diffracté d'ordre zéro premier respectif (61) et un faisceau diffracté d'ordre premier premier respectif (62) ;

f3) recevoir dudit dispositif de mesure de puissance optique (12) une valeur première respective de puissance optique de chaque faisceau diffracté d'ordre zéro premier (61) ;

f4) associer chaque valeur première de puissance optique à la valeur première respective de courant d'alimentation ;

g1) commander ledit premier actionneur (7) pour orienter ledit réseau de diffraction réfléchissant (6) dans ladite seconde position angulaire ;

g2) commander ladite source d'alimentation (3) pour alimenter ladite puce de gain (99) avec une pluralité de valeurs secondes de courant d'alimentation de sorte que ladite puce de gain (99) émette un faisceau lumineux second respectif (60') pour chaque valeur seconde de courant d'alimentation, ledit faisceau lumineux second respectif (60') générant un faisceau diffracté d'ordre zéro second respectif (63) et un faisceau diffracté d'ordre premier second respectif (64) ;

g3) recevoir dudit dispositif de mesure de puissance optique (12) une valeur seconde respective de puissance optique de chaque faisceau diffracté d'ordre zéro second (63) ;

g4) associer chaque valeur seconde de puissance optique à la valeur seconde respective de courant d'alimentation, et dans lequel ladite unité de traitement (90) est programmée et configurée pour exécuter les opérations suivantes :

i1) recevoir de ladite unité de commande et de contrôle (80) une première pluralité de paires de valeurs premières de courant d'alimentation et de puissance optique ;

i2) en fonction de ladite première pluralité et en fonction d'une première corrélation mathématique prédéterminée, calculer une efficacité quantique différentielle respective ;

m1) recevoir de ladite unité de commande et de contrôle (80) une seconde pluralité de paires de valeurs secondes de courant d'alimentation et de puissance optique ;

m2) en fonction de ladite seconde pluralité et en fonction d'une seconde corrélation mathématique prédéterminée, calculer un coefficient de gain modal respectif et une densité de porteurs à transparence respective ;

n) vérifier que ladite efficacité quantique différentielle respective, ledit coefficient de gain modal respectif et ladite densité de porteurs à transparence respective satisfont un critère de sélection prédéterminé respectif.

**8.** Système (100) selon la revendication 7, dans lequel ledit banc d'essai (1) comprend un thermostat (20) configuré pour maintenir ladite puce de gain (99), positionnée dans le dispositif de positionnement (2), stable en température, dans lequel ladite unité de commande et de contrôle (80) est connectée de manière opérative audit thermostat (20) et est programmée et configurée pour :

- pendant lesdites opérations f2), f3) et g2), g3), commander ledit thermostat (20) pour maintenir ladite puce de gain (99) à une première température ;
- répéter au moins lesdites opérations de f2) à f4) et lesdites opérations de g2) à g4) tout en maintenant ladite puce de gain (99) à une seconde température, dans lequel une différence en valeur absolue entre ladite première température et ladite seconde température est au moins égale à 4°C,

et dans lequel ladite unité de traitement (90) est programmée et configurée pour répéter lesdites opérations i1), i2), m1), m2), et n).

**9.** Système (100) selon la revendication 7 ou 8, dans lequel ledit banc d'essai (1) comprend :

- une lentille de collimation (4) interposée entre ledit dispositif de positionnement (2) et ledit réseau de diffraction réfléchissant (6) et configurée pour collimater ledit faisceau lumineux premier (60) et ledit faisceau lumineux second (60') ;
- un second actionneur multi-axes (5) configuré pour déplacer ladite lentille de collimation (4) dans l'espace ;
- un profileur de faisceau lumineux (9) aligné avec ledit dispositif de positionnement (2) et configuré pour mesurer un profil d'un faisceau lumineux ;
- un bras mécanique (8) configuré pour déplacer ledit réseau de diffraction réfléchissant (6) entre une position opérative, et une position non opérative dans laquelle ledit réseau de diffraction réfléchissant (6) n'intercepte pas lesdits faisceaux lumineux (60, 60').

**10.** Système (100) selon la revendication 9, dans lequel ladite unité de commande et de contrôle (80) est connectée de manière opérative audit profileur de faisceau lumineux (9), audit second actionneur (5), et audit bras mécanique (8), dans lequel ladite unité de commande et de contrôle (80) est programmée et configurée pour, de manière préliminaire :

- commander ledit bras mécanique (8) pour positionner ledit réseau de diffraction réfléchissant (6) dans ladite position non opérative ;
- commander ledit second actionneur (5) pour positionner ladite lentille de collimation (4) dans l'espace ;
- commander ladite source d'alimentation (3) pour alimenter ladite puce de gain (99) avec une valeur de test de courant d'alimentation de sorte que ladite puce de gain (99) émette un faisceau lumineux de test (70) qui est collimaté à travers ladite lentille de collimation (4) pour obtenir un faisceau lumineux de test collimaté (71) ;
- recevoir dudit profileur de faisceau lumineux (9) une mesure d'un profil dudit faisceau lumineux de test collimaté (71), et dans lequel ladite unité de traitement (90) est programmée et configurée pour recevoir de ladite unité de commande et de contrôle (80) ledit profil dudit faisceau lumineux de test collimaté (71) et vérifier que ledit profil satisfait un critère de profilage prédéterminé.

FIG.1

FIG.2

EP 4 616 496 B1

FIG.3

FIG.4

FIG.5

FIG.6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10732105 B1

- US 2012268743 A1

**Non-patent literature cited in the description**

- GaSb Swept-Wavelength Lasers for Biomedical Sensing Applications. **VIZBARAS AUGUSTINAS et al.** IEEE JOURNAL OF SELECTED TOPICS IN QUANTUM ELECTRONICS. IEEE, 06 November 2019, vol. 25, 1-12

- **G. P. AGRAWAL ; N.K. DUTTA**. *Semiconductor Lasers*